# EUROPEAN PATENT SPECIFICATION

(11) **EP 1 930 063 B1**
(45) Date of publication and mention of the grant of the patent: **17.11.2010**
(21) Application number: 07450223.8
(22) Date of filing: 05.12.2007
(51) Int. Cl.: B01D 47/02, C30B 29/54, C09B 67/00

(54) **Method for preparation of nanoparticles and apparatus for the production thereof**
Verfahren zur Herstellung von Nanopartikeln und Vorrichtung zu ihrer Herstellung
Procédé de préparation de nanoparticules et appareil pour sa production

(30) Priority: 05.12.2006 AT 20142006
(43) Date of publication of application: 11.06.2008
(73) Proprietor: Joanneum Research Forschungsgesellschaft mbH, 8010 Graz (AT)
(72) Inventor: Haase, Anja,, 8010 Graz (AT); Rom, Werner, 8010 Graz (AT); Köstler, Stefan, 8010 Graz (AT); Rudorfer, Andreas Mag., 8045 Graz (AT)
(74) Representative: Schwarz, Albin

(56) References cited:
- WO-A-03/039716
- JP-A- 2005 041 934
- US-A- 5 354 563
- US-B2- 6 837 918
- TAMAKI ET AL: "Tailoring nanoparticles of aromatic and dye molecules by eximer laser irradiation" APPLIED SURFACE SCIENCE, vol. 168, 2000, pages 85-88, XP002469534

## Description

The invention relates to a method for the production of organic nanoparticles and/or microcristals, to a stable dispersion of nanoparticles and/or microcrystals, the use of said stable dispersion and to an apparatus for the production of organic nanoparticles and/or microcrystals.

Organic semiconductors have attracted considerable interest for use as active channels in electronic and photonic devices, such as organic thin-film transistors (OTFTs), photovoltaic cells, and light modulators. These materials are compatible with plastic substrates and thus are advantageous for lightweight, large-area electronics applications that require structural flexibility. Thin-film transistors with organic semiconductors as active channel material have made significant progress in the past decade and their utility in active matrix displays, and integrated circuits has been demonstrated. The technology that is believed to have the highest potential for minimising the manufacturing cost of large area electronics requires the use of soluble organic semiconductors, which include polymers, oligomers, and other small molecules, for solution deposition. This approach, combined with direct patterning techniques, such as large area stamping, screen printing, and inkjet printing, are very attractive and suitable for relatively low-resolution patterning in the range 25-100µm.

Nanoparticles and microcrystals of organic semiconductor materials are interesting due to their special optical and electrical properties. Organic nanoparticles recently were also found to show some size dependent optical and nonlinear optical properties even in a rather big size range between 100 to 200 nm [H. Oikawa, H. Nakanishi: Optical Properties of Polymer Nanocrystals, in: H. Masuhara, H. Nakanishi, K. Sasaki (Eds.) Single Organic Nanoparticles (Springer, Heidelberg 2003)].

Especially polycyclic aromatic hydrocarbons are a very interesting class of materials. They show a very broad range of interesting properties like intensive colour, fluorescence, photoconductivity, semiconducting properties and a very special chemical and photochemical behaviour [see E. Clar: Polycyclic Hydrocarbons (Academic Press, New York 1964]. Therefore these materials are often used for pigments and dyes, fluorescent probes, etc. and they are promising materials for sensors, bioprobes and organic electronic devices like field effect transistors. The substances selected as model substances here, pentacene, tetracene and rubrene, are taken from this class of materials.

Pentacene (C₂₂H₁₄) is a semiconducting organic material currently attracting much interest among scientists and engineers because pentacene films can be used as a channel layer of OTFTs with mobilities of > 1 cm²/Vs. The pentacene films are usually polycrystalline when they are deposited by organic vapour phase deposition or thermal evaporation. So far, there is no polymer semiconducting material rivalling with the performance of pentacene in OTFTs.

Due to its outstanding carrier transport capabilities pentacene is a prominent candidate for the active semiconducting layer in organic thin film transistors. This compound crystallizes in a layered structure with herringbone arrangement within each layer. Pentacene appears in several polymorphic structures, which differ basically by their c-axis length. It is an organic p-type semiconductor with the best known electronic thin film properties so far.

Nevertheless, the thermal evaporation of pentacene films is time consuming and expensive. For an organic semiconductor technology to be competitive, the high mobility values must be combined with the processing advantages of organic molecules such as low processing temperatures and cheap large-area deposition. These deposition techniques, such as printing, often require solution processability. However, especially for the higher acenes, solubility is limited.

Recently, a novel approach for high-yield synthesis of soluble pentacene precursor using a Lewis acid catalysed Diels-Alder reaction of pentacene and N-sulfinylacetamide has been demonstrated (Afzali 2004). But each synthesis step requires additional purification and leads to a considerable amount of material loss and tedious working steps.

Tetracene (C₁₈H₁₂) is chemically very similar to pentacene and is also used as active layer in organic electronic devices. Charge carrier mobility in OTFT devices is lower than for pentacene but tetracene shows interesting photoconductive and electroluminescent properties and is a highly photoluminescent material what makes it a promising material for optoelectronic technology.

Rubrene (C₄₂H₂₈) is a substituted tetracene derivative and shows also high photoluminescence and charge carrier mobility. OTFT devices containing rubrene as the active layer were reported to show mobilities similar to or even better than pentacene. [see e.g. Katz H.E. Chem. Mater., 2004, 16, 4748-4756]

Solubility of rubrene and tetracene in organic solvents is higher than of pentacene but not sufficient to prepare (opto) electronic devices directly by solution processing. The problem of processing can be overcome by use of dispersed semiconducting nanoparticles in solution.

While there is abundant literature on the preparation and applications of inorganic semiconductor particles, reports on organic nanoparticles are relatively scarce. Different milling methods are well established for the preparation of organic pigment dispersions.
Such pigments typically have average particle sizes in the range of 0.1 to 10 micrometers, more typically 1 micrometer or greater. An overview over the mechanical devices most often used for milling pigments like bead mills, attritors, ball mills, etc. was given by Doroszkowski A. [see McKay R., Technological Applications of Dispersions, Marcel Dekker, New York, 1994]. An inherent disadvantage of mechanical milling of organic materials is that very broad particle size distributions are obtained. Furthermore milling times are typically in the range of several hours or even several days, especially if very fine particles are required. Another inherent disadvantage is that the organic particles are inevitably contaminated by substances from the mechanical parts especially abrasive wear.

A frequently used process to prepare pure organic nanoparticle dispersions of relatively narrow size distribution is the so called reprecipitation method. Here a solution of the organic material in a good solvent is added into an excess of a poor or non-solvent under vigorous stirring. The material precipitates and submicron sized particles are formed depending on temperature, concentration, stirring and other parameters [see H. Nakanishi, H. Oikawa: Reprecipitation Method for Organic Nanocrystals, in: H. Masuhara, H. Nakanishi, K. Sasaki (Eds.) Single Organic Nanoparticles ( Springer, Heidelberg 2003) or for a review on organic nanoparticles in aqueous media D. Horn, J. Rieger: Angew. Chem. Int. Ed. Vol. 40 (2001) p.4330-4361]. This technique has been used with or without addition of surfactants, in supercritical fluids or with the assistance of microwave irradiation and ultrasonication. Beside for many polymers and drug molecules, the reprecipitation method was also applied for semiconducting polyaromatic hydrocarbons like tetracene [Kim H.Y. et al., Langmuir 2003, 19, 3941-3946] and within a sol-gel matrix for rubrene and tetracene [Botzung-Appert E. et al., Chem. Mater., 2004, 16, 1609-1611]. Typical concentrations of the organic materials in the solutions before precipitation are in the millimolar range. As the non-solvent is typically used in about 100 fold excess it is clear that only very dilute organic nanoparticle dispersions are obtained by this method. So, for further processing of these dispersions like casting of films for different applications they have to be concentrated by several orders of magnitude. This is a very difficult and laborious process and can easily lead to destabilization of the dispersion. Also this process is not applicable at all for materials that are not or only sparingly soluble in organic solvents.

A method, based on laser ablation of organic crystals dispersed in a liquid has recently been introduced by Tamaki [see Tamaki Y. et al., Appl. Surf. Sci., 2000, 168, 85-88]. Here a coarse powder or large crystals of an organic material is dispersed in a solvent or surfactant solution by vigorous stirring. Then intense laser light is shined into the dispersion and strikes the crystal of organic material. Above a certain laser fluence threshold material evaporates from the surface of the crystals by a laser ablation mechanism and subsequently condenses in the surrounding liquid phase to form submicron or nanometer sized particles.

This method is only applicable to small volumes as nanoparticle production only proceeds directly in the laser beam. Sometimes very broad particle size distributions are found due to the involvement of a crystal cracking mechanism and the technique bears the risk of photochemical damage of sensitive organic materials.

Another method known in literature is the so called evaporation-condensation method. This is very similar to the usual thin film growth by physical vapour deposition (PVD) methods. The material is evaporated in vacuum into an inert atmosphere and deposited in the form of small aggregates onto a cooled substrate. [see H. Toyotama, 1994, US Patent 5354563] This method has been developed further in order to increase particle production rate by Brown [D.L. Brown, 1999, US Patent 5958329].

Numerous references have appeared describing use of the gas evaporation technique to produce ultrafine metal powders, especially magnetic metal/metal oxide powders (often referred to as magnetic pigments). These refer to a dry process and do not involve contact with liquids. Yatsuya et al., Jpn. J. Appl. Phys., 13, 749 (1974), involves evaporation of metals onto a thin film of a hydrocarbon oil (VEROS technique) and is similar to Kimura (supra). Nakatani et al., J. Magn. Magn. Mater., 65, 261 (1987), describe a process in which surface active agents are used to stabilize a dispersion of a ferromagnetic metal (Fe, Co, or Ni) vaporized directly into a hydrocarbon oil to give a ferrofluid using a metal atom technique. The metal atom technique requires high vacuum (pressures less than 10@-3 torr) such that discrete metal atoms are impinged onto the surface of a dispersing medium before the metal atoms have a chance to contact a second species in the gas phase. In this process, nucleation and particle growth occur in the dispersing medium, not in the gas phase. Additionally, U.S. Pat. No. 4,575,725 describes a process for making magnetic fluids which involves vaporization of a ferromagnetic metal, adiabatic expansion of the metal vapor and an inert gas through a cooling nozzle in order to condense the metal and form small metal particles, and impingement of the particles at high velocity onto the surface of a base liquid.

Another reference for dispersing materials that are delivered to a dispersing medium by means of a gas stream is known from US 1,509,824 which describes introduction of an atomized material generated either by vaporization or atomization, from a pressurized gas stream into a liquid medium such that condensation of the dispersed material occurs in the liquid. Therefore, particle growth occurs in the dispersing medium, not in the gas phase, as described above. The invention and the examples given relates to inorganic materials in their elemental form which have appreciable vapour pressures at room temperature. Therefore the contents of this invention relates only to a pure evaporation source without the need of a heated tubing and gas inlet system.

UK 736,590 describes a process whereby a finely divided pigment is carried by a gas stream, wetted by a liquid miscible with the final dispersing medium while the finely divided pigment is suspended in the gas stream, and then the wetted pigment is mixed with the dispersing medium. This method requires a pulverizer to first subject the pigment to mechanical forces prior to its introduction into the gas stream. Therefore, it suffers from the shortcomings cited above. Particle sizes on the order of 1 micrometer are obtained.

Kimura and Bandow, Bull. Chem. Soc. Japan, 56, 3578 (1983) disclose the non-mechanical dispersing of fine metal particles. This reference describes a method for preparing colloidal metal dispersions in nonaqueous media also using a gas evaporation technique. General references by C. Hayashi on ultrafine metal particles and the gas evaporation technique can be found in Physics Today, December 1987, p. 44 and J. Vac. Sci. and Tech., A5, p. 1375 (1987).

US 6 837 918 discloses a process and apparatus for collecting pigment nanoparticles vaporized pigment is condensed in insert gas to form nanoparticles.

US 4,104,276 discloses the conversion of crude copper phthalocyanine into a pigmentary form by introducing milled copper phthalocyanine into an organic or aqueous medium together with a basic copper phthalocyanine of specified formula.

Pigmented water-absorbable plastic materials, including contact lenses, are disclosed in US 4,638,025 to contain an organic binder, a pigment, a hydrophilic polymerizable plastic material, and a crosslinking agent. A binder such as cellulose acetate butyrate is required to keep the pigment in a dispersed form.

WO 03/039716 discloses a method and apparatus for producing pigment nanoparticles. A collection fluid spray contacts a vapour stream of the pigment to cause condensation.

It is therefore an object of the present invention to provide a method and an appartus for the forming of nanoparticles and/or microcrystals avoiding the drawbacks of the prior art and providing a simple way to form nanoparticles and/or microcristals.

The object is achieved by the inventive method as set forth in claim 1 for the production of organic nanoparticles and/or microcristals, the process comprising the steps of evaporating an organic material, thereby producing molecular dispersed vapour, and transporting said molecularly dispersed vapour by means of hot inert gas into a liquid condensation medium, thereby producing nanoparticles and/or microcristals forming a dispersion of said nanoparticles and/or microcristals in said liquid condensation medium by use of the inventive apparatus.

Further advantages are obvious from the dependent claims.

Advantageously, said liquid condensation medium is an aqueous medium and/or an organic liquid.

Said liquid condensation medium contains a dispersion stabilizer thus not allowing the dispersion to segregate.

Said dispersion stabilizer preferably is a surfactant or a soluble polymer.

The condensation medium advantageously contains said dispersion stabilizer up to 20 weight-%, preferably up to 10 weight-% and in particular up to 5 weight-%.

Preferably said organic material is selected from the groups of luminescent and/or semiconducting organic materials.

It is further an advantage that said semiconducting organic material is selected from pentacene, rubrene and tetracene.

In a preferred embodiment, the method is a semicontinuous process, wherein the liquid condensation medium is continuously fed into a liquid container and the obtained organic particle dispersion is continuously withdrawn from said liquid container.

Advantageously, a stable dispersion of nanoparticles and/or microcrystals with a size in the range between 20 and 500 nm, in particular between 80 and 200 nm, in a liquid medium containing 1-10 weight-% of said nanoparticles and/or microcrystals and a stabilizer, can be obtained by the inventive method.

The use of a stable dispersion for the production of an organic (opto)electronic device or an optical sensor is advantageous.

An apparatus for the production of organic nanoparticles, according to the invention is set forth in claim 9, and comprises a tube shaped container comprising means for heating, means for feeding an inert gas to said container, a reaction vessel containing a liquid condensation medium connected to said container, and an orifice at the end of the container located below a liquid level of the liquid condensation medium in the reaction vessel.

Advantageously the apparatus contains preheating means located upstream from the heating means in order to preheat the inert gas thus shortening the risk of condensation of the gas in the inner tube.

The apparatus contains a pumping system located downstream of the reaction vessel thus allowing a continuous stream of gas to enter the reaction vessel.

According to another advantageous aspect of the invention, a mass flow control unit is arranged on the inert gas feeding means.

Furthermore, the method requires no mechanical energy, such as ultrasound, in order to break up aggregates. Aggregates do not form since there is no isolation of dry ultrafine pigment particles prior to contacting the dispersing medium.

A preferred embodiment of the invention is described in detail referring to the drawings. In the figures:

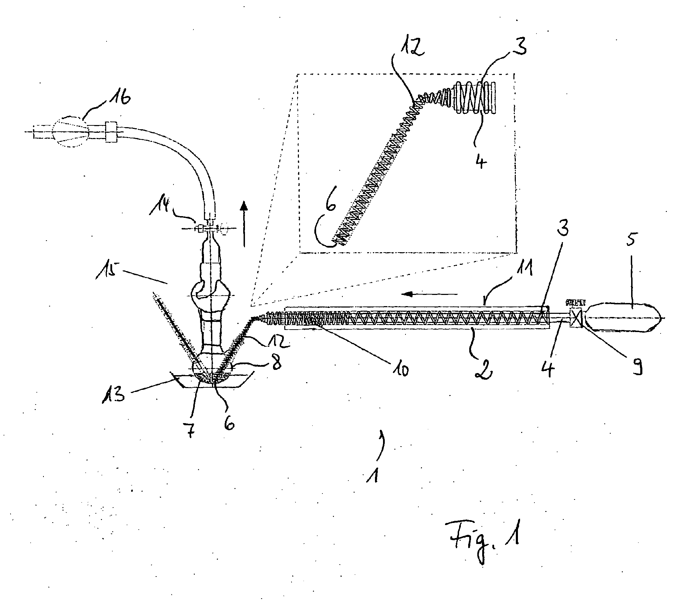

- Fig. 1: shows a preferred embodiment of the inventive apparatus.

A new method to produce stable dispersions of organic nanoparticles in an aqueous or organic solvent is described in the following. In this method the organic material is evaporated via heating in a tube, heated by an electrical heating band. The evaporated organic material is transported with the help of an inert gas stream and subsequently led into a solution of a dispensing agent in a liquid held at low temperatures. In here, the organic volatile material is condensed and thus dispersed as nanometre sized particles.

The dispersions of the present invention are prepared by a gas evaporation technique which generates ultrafine organic particles. Bulk material is heated under reduced pressure until vaporization occurs. The organic material presence of a gas stream wherein the gas preferably is inert (nonreactive), although any gas which does not react with the organic material may be used. The ultrafine particles are transported to a liquid dispersing medium by the gas stream and deposited therein by bubbling the gas stream into or impinging the gas stream onto the dispersing medium.

An apparatus for providing dispersions of submicron sized organic particles comprises:
a) a furnace connected to a collection vessel, the furnace containing a heating means (e.g., resistive, inductive, e-beam, infrared, laser, plasma jet) and adapted to contain a heated gas inlet tube, and a means (e.g., a pump such as a rotary oil pump, an oil diffusion pump, piston pump, a Roots.TM. blower, and a turbomolecular pump) for evacuating the furnace and the collection vessel, the vessel containing a dispersing medium;
b) means (e.g., a ceramic, plastic, or metal crucible or slab that can be preloaded with material or which can be continuously or batch-wise fed during operation of the apparatus, or the electrodes can be the means) for introducing an organic or inorganic pigment or pigment precursor into said furnace and evacuation thereof;
c) means (e.g., a micro metering valve, electronic flow controller, or gas dispersing tube) for introducing through the inlet tube an inert gas stream into the furnace;
d) means (e.g., energy input as by e-beam, infrared, laser, inductive, resistive, or plasma jet) for evaporating the organic material into the inert gas stream;
e) means (e.g., energy input as by e-beam, infrared, laser, inductive, resistive, or plasma jet) for maintaining the whole tubing system, downstream from the evaporation zone, guiding the inert gas stream containing the organic material vapour, above the condensation temperature of the organic material vapour.
f) optionally, means (e.g., resistive, inductive, e-beam, infrared, laser, plasma jet) for preheating the inert gas stream, located upstream to the evaporation zone.
g) optionally, means (e.g., a micro metering valve, electronic flow controller, or gas dispersing tube) for introducing into the furnace a second, gas stream (different inert gas or reducing gas (e.g. H₂))
h) means for condensing the vapour of the organic material in a liquid dispersion media (e.g. vessel or flask) to which the dispersing media can be continuously or batch-wise fed and the particle dispersion can be continuously or batch-wise withdrawn.
i) optionally, means (e.g. cooling bath, convective, electric, evaporation cooling, thermostat, heat exchanger) to control the temperature of the collection vessel and to dissipate the heat introduced by the hot inert gas stream.

In the following, a preferred embodiment of the inventive apparatus is decribed referring to Fig. 1. The embodiment of the apparatus 1 consists of a horizontal glass tube 2 which is heatable by a heating coil 3 extending along an inner glas tube 4 and purged with a gas stream. A first end of the glass tube 2 serves as inlet for the purging gas from an inert gas supply 5, while a second end of the glass tube 2 has an orifice 6 within a dispersing liquid 7 in a collection vessel 8 like a round-bottomed flask. The glass tube 2 can be heated up to the orifice 6 into the liquid 7. The gas, which is in most cases an inert gas, is introduced via a mass flow control unit 9. The gas stream the direction of which is indicated by the arrows can be pre-heated in a pre-heating zone 11 upstream of a location of the organic material. In an evaporation zone 10, the organic material is evaporated and the gas stream is heated to a temperature high enough to prevent condensation of the organic material.

The inert gas stream passes the evaporation zone 10 and transports the gaseous material into the dispersing liquid 7 by bubbling the gas containing the vapour into the dispersing liquid 7. The dispersing liquid 7 is cooled by a cooling liquid in a cooling bath 13. The main inventive feature of the invention is a second heating coil 12 for the gas stream right before the gas is introduced into the dispersing liquid 7. Here the gas is heated up to a temperature which prevents condensation of the organic material, especially condensation of the organic material on the walls of the tubing system and clogging of the tubing system. In the dispersing liquid 7 the organic material is condensed and immediately stabilised by a surface active agent contained in the dispersing liquid 7.

The apparatus 1 can further comprise valves 14 and an anticlimb adaptor 15 to prevent the dispersion liquid 7 from being drawn from the collection vessel 8 by a vacuum pump 16.

The present invention differs from that of H. Toyotama in that the vacuum provided is dynamic and a constant flow of inert gas stream is swept past the vaporization source, at rates that can be generally in the range of 5 to 2000 SCCM (standard cc's per minute) for a laboratory scale apparatus, during material evaporation. Thus, while Toyotama is dependent on the residence time of the ultrafine particles in the growth zone (see Granqvist and Buhrman, J. Appl. Phys., 47, (1976), p. 2200) to determine the ultimate particle size obtained for a given pressure, the instant invention provides an organic material vapour which is condensed after injection into the liquid dispersing medium. Therefore the particle size and shape is independent of the residence time in the gas phase. Furthermore, after the vapour of organic material is introduced into the dispersing medium the condensed material is stabilized by the dispersing medium before it has a chance to and aggregate, thus removing the need for external mechanical energy, such as ultrasound, to achieve a dispersed state.

Typical organic materials for the use in this invention are Pentacene, Rubrene, or tetracene. The nanoparticles and/or microcrystals obtained in the stable dispersion show sizes in a range between 1 and 500 nm, in particular between 20 and 300 nm, more particularly between 80 and 200 nm, in a liquid medium containing 1-10 weight-% of said nanoparticles and/or microcrystals and a stabilizer.

The dispersing medium may be a pure liquid or a mixture of liquids and may contain additional ingredients, including inorganic and organic soluble materials and mixtures thereof. Such additives include surface active agents, soluble polymers, organic molecules, insoluble particulates, acids, bases, and salts.

By surface active agent is meant an additive that has a preferred spatial orientation at an interface, e.g. large molecules having a hydrophilic head group and a hydrophobic tail (e.g. long chain carboxylic acids, long chain quaternary ammonium salts) or polymers (e.g. Block copolymers, polyelectrolytes). The weight percent of surface active agent to dispersing medium can be from 0 to 20%, preferably 0 to 10%, and more preferably 0 to 5%. Other surface active agents useful in the present invention are well known to those skilled in the art.

The inert gas can be virtually any gas that does not react with the organic material under the conditions of the experiment. Typical choices are He, Ne, Ar, Xe, and N2. Mixtures of two or more inert gases can also be used. A mixture of an inert gas and a reducing gas (e.g. H₂) may also be used if the organic material is susceptible to oxidation.

Temperatures for evaporation of the organic material useful in the method of the present invention depend on the type of the organic material being used and generally range from 25°C to around 500°C.

In addition to resistive heating, other means of applying heat to the organic material may be envisioned. These include laser heating, inductive heating, plasma jet, plasma arc discharge, and others known to those skilled in the art.

Temperatures of the dispersing medium useful in the method of the present invention depend on the particular medium being used and generally range from -78 °C to 150°C, preferably from -50 °C to 50°C., and most preferably from -20 °C to 10°C.

Pressures useful in the method of the present invention range from about 1 to 1013 mbar, preferably from 10 to 200 mbar.

The dispersions of the present invention are particularly suitable for further processing by different film forming and patterning techniques often employed in electronics and optics technology. These include e.g. spin coating, dip coating, and spray coating as well as printing techniques (such as e.g. inkjet printing) and other dispersion processing techniques well known to those skilled in the art. After further processing as mentioned above, the dispersions of the present invention are particularly suitable for the production of organic (opto)electronic devices and optical sensor systems.

A dispersion according to the present invention is prepared by a method comprising the following steps:
a) vaporizing an organic material in the presence of an inert gas stream to provide a molecularly dispersed state,
b) transporting the vapour of the organic material with the inert gas stream through a heated tubing system into a liquid dispersing medium, e.g. by bubbling the inert gas stream containing the molecularly dispersed material through the liquid dispersing medium,
c) condensing the vapour of organic material in the liquid to form submicron sized particles, and
d) stabilizing the formed submicron sized particles by adsorption of a surface active component or polymer on the surface.

Objects and advantages of this invention are further illustrated by the following examples, but the particular materials and amounts thereof recited in these examples, as well as other conditions and details, should not be construed to unduly limit this invention.

### Example 1:

200 mg of Pentacene are placed in a metal crucible and transfered into the sublimation area of a sublimation apparatus according to figure 1. 60 ml of a solution containing surface active agents (e.g. sodium dodecylsulfate) and a foam inhibitor (e.g. Surfynol E104) are added to the round bottom flask. The solution is cooled down by an ice bath to avoid excessive evaporation. The whole system is flushed with inert gas and pumped to a pressure below 100 mbar prior to the heating process. The gas flow is set to 30 Sccm/min. All heating coils, including the gas tube are heated up close to the sublimation temperature of the material within 15 minutes. After that the temperature in the sublimation area is raised till sublimation starts (appr. 300°C). The vapor is transported by the auxiliary inert gas directly into the vessel containing the stabilizing solution. The organic material is condensed in the liquid and particles in the nanometre scale are formed which are immediately stabilized by the surface active component present in the solution. Heating is maintained till all the organic material in the crucible is evaporated. After cooling down the system is filled with inert gas until reaching ambient pressure. Afterwards the nanoparticle dispersion can be removed for further processing.

### Example 2:

200 mg of Tetracene are placed in a metal crucible and transfered into the sublimation area of a sublimation apparatus according to figure 1. 60 ml of a solution containing surface active agents and a foam inhibitor (e.g. Surfynol E104) are added to the round bottom flask. The solution is cooled down by an ice bath to avoid excessive evaporation. The whole system is flushed with inert gas and pumped to a pressure below 100 mbar prior to the heating process. The gas flow is set to 30 Sccm/min. All heating coils, including the gas tube are heated up close to the sublimation temperature of the material within 15 minutes. After that the temperature in the sublimation area is raised till sublimation starts (appr. 200°C). The vapor is transported by the auxiliary inert gas directly into the vessel containing the stabilizing solution. The organic material is condensed in the liquid and particles in the nanometre scale are formed which are immediately stabilized by the surface active component present in the solution. Heating is maintained till all the organic material in the crucible is evaporated. After cooling down the system is filled with inert gas until reaching ambient pressure. Afterwards the nanoparticle dispersion can be removed for further processing.

## Claims

1. A method for the production of organic nanoparticles and/or microcristals, the process comprising the steps of:
- evaporating an organic material, thereby producing molecular dispersed vapour, and
- transporting said molecularly dispersed vapour by means of hot inert gas into a liquid condensation medium, thereby producing nanoparticles and/or microcristals forming a dispersion of said nanoparticles and/or microcristals in said liquid condensation medium.

2. A method according to claim 1, wherein said liquid condensation medium is an aqueoues medium and/or an organic liquid.

3. A method according to claim 2, wherein said liquid condensation medium contains a dispersion stabilizer.

4. A method according to claim 3, wherein said dispersion stabilizer is a surfactant or a soluble polymer.

5. A method according to claim 4, wherein said the condensation medium contains said dispersion stabilizer up to 20 weight-%, preferably up to 10 weight-% and in particular up to 5 weight-%.

6. A method according to one of the preceding claims wherein said organic material is selected from the groups of luminescent and/or semiconducting organic materials.

7. A method according to claim 6, wherein said semiconducting organic material is selected from pentacene, rubrene and tetracene.

8. A method according to one of the preceding claims, wherein the method is a semicontinuous process, wherein the liquid condensation medium is continuously fed into a liquid container and the obtained organic particle dispersion is continuously withdrawn from said liquid container.

9. An apparatus for the production of organic nanoparticles comprising a tube shaped container (2) comprising means for heating (3, 12), means for feeding an inert gas (5) to said container, a reaction vessel (8) containing a liquid condensation medium (7) connected to said container, and an orifice (6) at the end of the container (2) located below a liquid level of the liquid condensation medium (7) in the reaction vessel (8), wherein the means for heating (3, 12) extends to the orifice (6) at the end of the container (2).

10. An apparatus according to claim 9, wherein the apparatus contains preheating means located upstream from the heating means in order to preheat the inert gas.

11. An apparatus according to claim 9 or 10, wherein the apparatus contains a pumping system (16) located downstream of the reaction vessel.

12. An apparatus according to one of the claims 9 to 11, wherein a mass flow control unit (9) is arranged on the inert gas feeding means.

## Patentansprüche

1. Verfahren zur Herstellung von organischen Nanopartikeln und/oder Mikrokristallen, wobei der Prozess die folgenden Schritte umfasst:
- Verdampfen eines organischen Materials, wodurch ein dispergierter Molekulardampf erzeugt wird, und
- Transportieren des molekular dispergierten Dampfes mittels eines heißen Inertgases in ein flüssiges Kondensationsmedium, wodurch Nanopartikel und/oder Mikrokristalle erzeugt werden, die eine Dispersion aus den Nanopartikeln und/oder Mikrokristallen im flüssigen Kondensationsmedium bilden.

2. Verfahren gemäß Anspruch 1, wobei das flüssige Kondensationsmedium ein wässriges Medium und/oder eine organische Flüssigkeit ist.

3. Verfahren gemäß Anspruch 2, wobei das flüssige Kondensationsmedium einen Dispersionsstabilisator enthält.

4. Verfahren gemäß Anspruch 3, wobei der Dispersionsstabilisator ein oberflächenaktiver Stoff oder ein lösliches Polymer ist.

5. Verfahren gemäß Anspruch 4, wobei das Kondensationsmedium den Dispersionsstabilisator in einer Menge von bis 20 Gew.-%, vorzugsweise bis zu 10 Gew.-% und insbesondere bis zu 5 Gew.-% enthält.

6. Verfahren gemäß einem der vorhergehenden Ansprüche, wobei das organische Material aus der Gruppe der lumineszierenden und/oder halbleitenden organischen Materialien ausgewählt ist.

7. Verfahren gemäß Anspruch 6, wobei das halbleitende organische Material aus Pentacen, Rubren und Tetracen ausgewählt ist.

8. Verfahren gemäß einem der vorhergehenden Ansprüche, wobei das Verfahren ein halbkontinuierlicher Prozess ist, wobei das flüssige Kondensationsmedium kontinuierlich in einen Flüssigkeitsbehälter zugeführt und die erhaltene organische Teilchendispersion kontinuierlich aus dem Flüssigkeitsbehälter abgezogen wird.

9. Vorrichtung zur Herstellung von organischen Nanopartikeln, umfassend einen rohrförmigen Behälter (2), umfassend Mittel zum Erhitzen (3, 12), Mittel zum Zuführen eines Inertgases (5) in den Behälter, ein Reaktionsgefäß (8), enthaltend ein flüssiges Kondensationsmedium (7), das mit dem Behälter verbunden ist, sowie eine Öffnung (6) am Ende des Behälters (2), die unterhalb eines Flüssigkeitspegels des flüssigen Kondensationsmediums (7) im Reaktionsgefäß (8) angeordnet ist, wobei das Mittel zum Erhitzen (3, 12) sich zur Öffnung (6) am Ende des Behälters (2) erstreckt.

10. Vorrichtung gemäß Anspruch 9, wobei die Vorrichtung Mittel zum Vorerhitzen enthält, die stromaufwärts vom Mittel zum Erhitzen angeordnet sind, um das Inertgas vorzuerhitzen.

11. Vorrichtung gemäß Anspruch 9 oder 10, wobei die Vorrichtung ein Pumpsystem (16) enthält, das stromabwärts des Reaktionsgefäßes angeordnet ist.

12. Vorrichtung gemäß einem der Ansprüche 9 bis 11, wobei eine Massendurchflussregelungseinheit (9) am Inertgas-Zufuhrmittel angeordnet ist.

## Revendications

1. Procédé pour la production de nanoparticules et/ou de microcristaux organiques, le procédé comprenant les étapes :
- d'évaporation d'un matériau organique, produisant par ce moyen une vapeur moléculaire dispersée, et
- de transport de ladite vapeur moléculairement dispersée au moyen d'un gaz inerte chaud dans un milieu de condensation liquide, produisant par ce moyen des nanoparticules et/ou microcristaux formant une dispersion desdites nanoparticules et/ou microcristaux dans ledit milieu de condensation liquide.

2. Procédé selon la revendication 1, dans lequel ledit milieu de condensation liquide est un milieu aqueux et/ou un liquide organique.

3. Procédé selon la revendication 2, dans lequel ledit milieu de condensation liquide contient un stabilisant de dispersion.

4. Procédé selon la revendication 3, dans lequel ledit stabilisant de dispersion est un surfactant ou un polymère soluble.

5. Procédé selon la revendication 4, dans lequel ledit milieu de condensation contient ledit stabilisant de dispersion jusqu'à 20 % en poids, de préférence jusqu'à 10 % en poids et en particulier jusqu'à 5 % en poids.

6. Procédé selon l'une des revendications précédentes, dans lequel ledit matériau organique est choisi dans les groupes des matériaux organiques luminescents et/ou semi-conducteurs.

7. Procédé selon la revendication 6, dans lequel ledit matériau organique semi-conducteur est choisi parmi le pentacène, le rubrène et le tétracène.

8. Procédé selon l'une des revendications précédentes, dans lequel le procédé est un procédé semi-continu, dans lequel le milieu de condensation liquide est alimenté de manière continue dans un récipient de liquide et la dispersion de particules organiques obtenue est prélevée de manière continue dudit récipient de liquide.

9. Appareil pour la production de nanoparticules organiques comprenant un récipient en forme de tube (2) comprenant un moyen pour chauffer (3, 12), un moyen pour alimenter un gaz inerte (5) vers ledit récipient, un récipient de réaction (8) contenant un milieu de condensation liquide (7) relié audit récipient, et un orifice (6) à l'extrémité du récipient (2) situé sous un niveau de liquide du milieu de condensation liquide (7) dans le récipient de réaction (8), dans lequel le moyen pour chauffer (3, 12) s'étend jusqu'à l'orifice (6) à l'extrémité du récipient (2).

10. Appareil selon la revendication 9, dans lequel l'appareil contient un moyen de préchauffage situé en amont du moyen de chauffage afin de préchauffer le gaz inerte.

11. Appareil selon la revendication 9 ou 10, dans lequel l'appareil contient un système de pompage (16) situé en aval du récipient de réaction.

12. Appareil selon l'une des revendications 9 à 11, dans lequel une unité de commande d'écoulement de masse (9) est agencée sur le moyen d'alimentation de gaz inerte.
